Europäisches Patentamt

European Patent Office

Office européen des brevets

(11) Veröffentlichungsnummer : **0 387 379 B1**

## (12) EUROPÄISCHE PATENTSCHRIFT

(45) Veröffentlichungstag der Patentschrift :
**18.01.95 Patentblatt 95/03**

(51) Int. Cl.$^6$ : **G11C 11/409,** G11C 29/00

(21) Anmeldenummer : **89104715.1**

(22) Anmeldetag : **16.03.89**

(54) **Integrierter Halbleiterspeicher vom Typ DRAM und Verfahren zu seinem Testen.**

(43) Veröffentlichungstag der Anmeldung :
**19.09.90 Patentblatt 90/38**

(45) Bekanntmachung des Hinweises auf die
Patenterteilung :
**18.01.95 Patentblatt 95/03**

(84) Benannte Vertragsstaaten :
**AT DE FR GB IT NL**

(56) Entgegenhaltungen :
**DE-A- 2 462 220**
**GB-A- 2 184 311**
**IBM TECHNICAL DISCLOSURE BULLETIN,**
**Band 20, Nr. 11A, Avril 1978, Seiten 4299-4300,**
**New York, US; R.H. LINTON: "Memory noise**
**compensation network"**

(56) Entgegenhaltungen :
**IBM TECHNICAL DISCLOSURE BULLETIN,**
**Band 20, Nr. 11A, April 1978, Seiten 4297-4298,**
**New York, US; R.H. LINTON: "Technique for**
**optimizing signals in dynamic memory sy-**
**stems"**

(73) Patentinhaber : **SIEMENS**
**AKTIENGESELLSCHAFT**
**Wittelsbacherplatz 2**
**D-80333 München (DE)**

(72) Erfinder : **Hoffmann, Kurt, Dr. Prof.**
**Nelkenweg 20**
**D-8028 Taufkirchen (DE)**
Erfinder : **Kraus, Rainer, Dr.**
**Weidener Strasse 21**
**D-8000 München 83 (DE)**
Erfinder : **Kowarik, Oskar, Dr.**
**Goethering 70**
**D-8018 Grafing (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die vorliegende Erfindung betrifft einen integrierten Halbleiterspeicher vom Typ DRAM nach dem Oberbegriff des Patentanspruches 1 sowie ein Verfahren zum Testen eines Halbleiterspeichers nach dem Oberbegriff des Patentanspruches 10.

Gattungsgemäße integrierte Halbleiterspeicher sind beispielsweise aus folgenden Veröffentlichungen bekannt:

- GB-A- 2 184 311, die auch dem Oberbegriff des Anspruchs 1 bildet,
- IEEE Journal of Solid-State Circuits, Vol. SC-20, No. 5, October 1985, Seiten 903 bis 908, "A 1-Mbit CMOS DRAM with fast Page Mode and Static Column Mode". Die Veröffentlichung offenbart einen gattungsgemäßen integrierten Halbleiterspeicher mit sog. "complementary capacitor coupled dummy cells". Als Dummy-Zellen sind dabei auch traditionelle Dummy-Zellen vorstellbar, d.h. Dummy-Zellen, die als 1-Transistor-Speicherzellen ausgelegt sind.
- IEEE Journal of Solid-State Circuits, Vol. SC-22, No. 5, October 1987, Seiten 651 bis 656, "A 65-ns 4-Mbit CMOS DRAM with a Twisted Driveline Sense Amplifier" und
- 1984 IEEE International Solid-State Circuits Conference, ISSCC 84, February 24, 1984, Seiten 278, 279 und 354 mit dem Titel "A Sub 100ns 256K DRAM in CMOS III Technology". Beide Veröffentlichungen zeigen gattungsgemäße integrierte Halbleiterspeicher ohne Dummy-Zellen.

Bei der Prüfung von integrierten Halbleiterspeichern vom DRAM-Typ wäre es oft erstrebenswert, außer den üblicherweise erfaßbaren Eigenschaften wie Stromaufnahme, Funktionsfähigkeit, Empfindlichkeit auf bestimmte Prüfmuster auch Eigenschaften erfassen zu können, die den Arbeitsbereich verschiedener Teilschaltungen eines Halbleiterspeichers bestimmen (z.B. Zellkapazitäten, Symmetrie von Speicherzellen an Bitleitungen und Referenzbitleitungen, Symmetrie von Bewerterschaltungen). Dies ist bei fertigmontierten Bausteinen bislang nur möglich beispielsweise durch Anlegen von Versorgungspotentialen mit Werten außerhalb des durch eine Spezifikation begrenzten Wertebereiches. Entsprechendes gilt für Pegel von Eingangssignalen. Auf Waferebene ist es bislang zusätzlich möglich, beispielsweise mit Hilfe von sog. Zusatzpads, die nur bei einem noch nicht mit einem Gehäuse versehenen Halbleiterspeicher zugänglich sind, Hilfssignale und/oder Hilfspotentiale zu Analyse- und Testzwecken zuzuführen. Eine weitere Analysemöglichkeit auf Waferebene ist eine gezielte Bestrahlung des Halbleiterspeichers mit Alpha-Partikeln. Alle diese Möglichkeiten stellen jedoch einen ziemlich globalen Einfluß auf den Halbleiterspeicher dar, d.h. es werden meist auch Gebiete außerhalb des Speicherzellenfeldes unerwünscht beeinflußt.

Aufgabe der vorliegenden Erfindung ist es, einen integrierten Halbleiterspeicher zu schaffen, der bei vertretbarem Mehraufwand in Entwicklung und Fertigung Einrichtungen enthält, die ein gezieltes Prüfen und Analysieren eines Zellenfeldes ermöglichen, ohne den Normalbetrieb negativ zu beeinflussen. Es ist auch wünschenswert, daß das Prüfen und Analysieren auch bei einem fertigmontierten Halbleiterspeicher möglich ist. Weiterhin soll auch ein entsprechendes Testverfahren angegeben werden.

Die Aufgabe wird bei einem gattungsgemäßen integrierten Halbleiterspeicher gelöst durch die kennzeichnenden Merkmale der Patentansprüche 1 und 10. Vorteilhafte Aus- und Weiterbildungen sind in Unteransprüchen gekennzeichnet.

Im folgenden wird die Erfindung anhand von FIG näher erläutert.

Es zeigen:

FIG 1                    einen Ausschnitt aus einem Halbleiterspeicher nach dem Stande der Technik,
FIG 2                    ein Impulsdiagramm zur Anordnung nach FIG 1,
FIG 3, 8 bis 10          erfindungsgemäße Anordnungen,
FIG 4                    ein Impulsdiagramm zur Anordnung nach FIG 3,
FIG 5 bis 7              verschiedene Impulsdiagramme ausschnittsweise und vergrößert dargestellt.

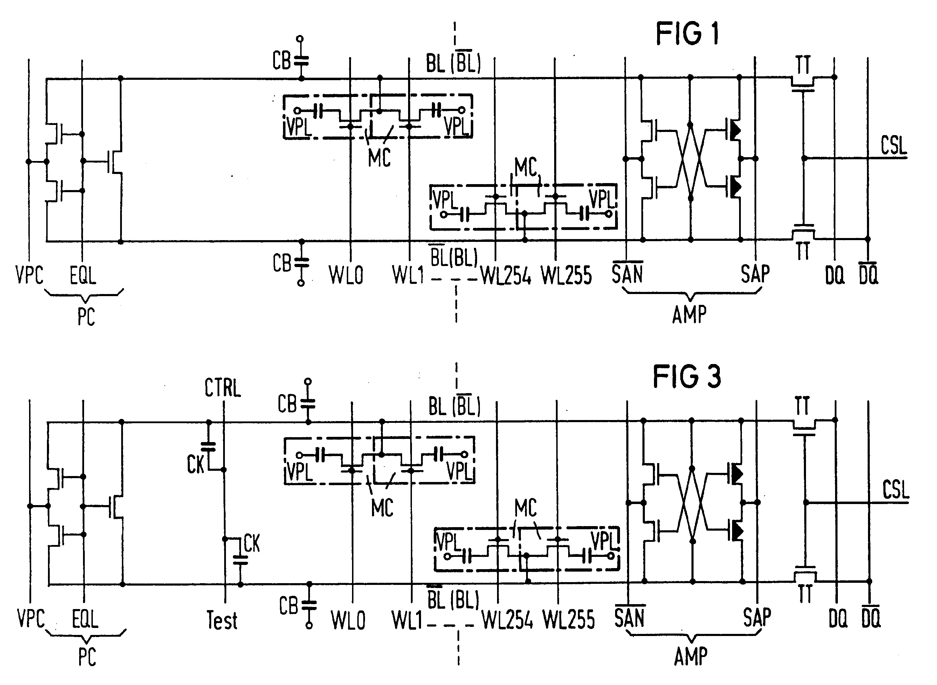

Integrierte Halbleiterspeicher nach dem Stande der Technik enthalten matrixförmig angeordnete, über Wortleitungen und Bitleitungen (als Teil von Bitleitungspaaren) adressierbare Speicherzellen. FIG 1 zeigt ausschnittsweise ein Bitleitungspaar BL,$\overline{BL}$ samt seinen parasitär vorhandenen Bitleitungskapazitäten CB, Speicherzellen MC sowie diesen zugeordnete Wortleitungen WL, die zur Unterscheidung voneinander durchnumeriert sind von 0 (WL0) bis beispielsweise 255 (WL255). Sie zeigt weiterhin eine Precharge-Einrichtung PC. Bekanntlich wird im Betrieb vor Auslesen von Informationen aus einer Speicherzelle MC das Bitleitungspaar BL,$\overline{BL}$ auf ein Precharge-Potential VPC vorgeladen. Dazu wird ein Ausgleichssignal EQL an die Precharge-Einrichtung PC angelegt, wodurch das Precharge-Potential VPC an das Bitleitungspaar BL,$\overline{BL}$ gelangt und dieses auf das Precharge-Potential VPC auflädt. Die Speicherzellen MC sind bei den bekannten Halbleiterspeichern vom Typ DRAM üblicherweise als sog. 1-Transistor-Speicherzellen ausgeführt, die wenigstens einen Speicherkondensator und einen Auswahltransistor enthalten. Die Speicherkondensatoren sind dabei mit ihrem einen Anschluß mit einem sog. Plattenpotential VPL verbunden. Nach dem Vorladen wird zum Auslesen von Informationen aus einer Speicherzelle MC deren Auswahltransistor über eine mit ihm verbundene Wortleitung WL elektrisch leitend geschaltet (= die Speicherzelle MC wird adressiert), wodurch die im Speicherkondensator gespeicherte Ladung als gespeicherte Information auf die der Speicherzelle MC zugeordnete Bitleitung BL des Bitleitungspaares BL,$\overline{BL}$ gelangt. Ein Bitleitungspaar besteht aus zwei Leitungen, der sog. Bitleitung BL und der sog. Referenzbitleitung $\overline{BL}$. Diejenige Leitung, die mit der adressierten Speicherzelle MC verbunden ist, wird als Bitleitung BL bezeichnet. Entsprechend wird diejenige Leitung, die nicht mit der adressierten Speicherzelle MC verbunden ist, sondern mit anderen Speicherzellen MC desselben Bitleitungspaares, als Referenzbitleitung $\overline{BL}$ bezeichnet. Soll beispielsweise eine der Speicherzellen MC ausgelesen werden, die mit einer der Wortleitungen WL0,WL1 verbunden sind, so werden die in FIG 1 oben liegende Leitung als Bitleitung BL bezeichnet und die in FIG 1 unten liegende Leitung als Referenzbitleitung $\overline{BL}$ bezeichnet. Soll jedoch beispielsweise eine der Speicherzellen MC ausgelesen werden, die mit einer der Wortleitungen WL254,WL255 verbunden sind, so werden die in FIG 1 unten liegende Leitung als Bitleitung BL bezeichnet (in FIG 1 in Klammern gesetzt) und die in FIG 1 oben liegende Leitung als Referenzbitleitung $\overline{BL}$ bezeichnet (in FIG 1 ebenfalls in Klammern gesetzt). Zum einfacheren Verständnis wird nachfolgend zugrunde gelegt, daß aus der mit der Wortleitung WL0 verbundenen Speicherzelle MC auszulesen ist. Wegen der Allgemeingültigkeit dieser Beschreibung wird anstelle des Bezugszeichens WL0 künftig allgemein das Bezugszeichen WL verwendet.

Die auf der Bitleitung BL nach dem Auslesen anliegende Information, künftig "das Lesesignal" genannt, wird anschließend mittels einer Bewerterschaltung AMP bewertet und verstärkt. Dadurch nimmt das Lesesignal den ihm zugeordneten logischen Pegel ("0" oder "1") an. Entsprechend bildet sich auf der Referenzbitleitung $\overline{BL}$ ein dazu komplementäres Signal aus mit einem entsprechenden komplementären logischen Pegel ("1" oder "0"). Moderne Bewerterschaltungen AMP sind meist als zwei parallelgeschaltete dynamische Flip-Flops aus jeweils kreuzgekoppelten Transistoren gestaltet. Das eine Flip-Flop enthält dabei im allgemeinen Transistoren vom n-Kanal-Typ; das andere Flip-Flop solche vom p-Kanal-Typ. Die Flip-Flops werden in diesem Falle durch zwei Taktsignale SAP und $\overline{SAN}$ gesteuert. Dies ermöglicht ein schnelles Ansprechen der Bewerterschaltung AMP sowie anschließend daran ein Zurückschreiben der ausgelesenen und verstärkten Informationen in die ausgelesene Speicherzelle MC mit vollwertigen logischen Pegeln. Über durch einen Dekoder (nicht dargestellt) gesteuerte Transfertransistoren TT gelangt die bewertete und verstärkte Information an Datenausgangsleitungen DQ, $\overline{DQ}$.

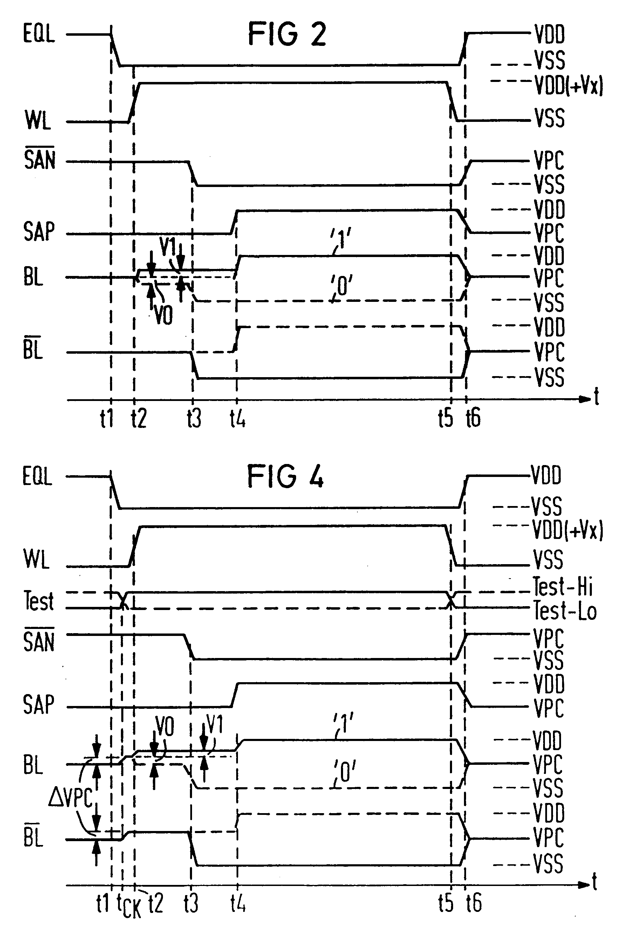

Der Ablauf des gesamten Vorganges ist in FIG 2 in Form eines Impulsdiagrammes dargestellt: Vor Beginn des beschriebenen Lese- und Bewertevorganges ist das Ausgleichssignal EQL aktiv zur Durchführung des Vorladevorganges; alle anderen Signale sind inaktiv. Dadurch nehmen die Bitleitung BL und die Referenzbitleitung $\overline{BL}$ das Precharge-Potential VPC an. Zu einem Zeitpunkt t1, der nach einer Übernahme und Dekodierung von an den Halbleiterspeicher anzulegenden Adressen liegt, wird das Ausgleichssignal EQL inaktiv geschaltet; der Vorladevorgang ist beendet. Zu einem Zeitpunkt t2 wird die Wortleitung WL aktiviert. Dadurch wird die in der adressierten Speicherzelle MC gespeicherte Information auf die Bitleitung BL ausgelesen. Entspricht die ausgelesene Information einer log. 1, so wird durch das Auslesen das auf der Bitleitung BL liegende (Precharge-)Potential VPC um einen dem Lesesignal entsprechenden Betrag V1 erhöht. Entspricht die ausgelesene Information jedoch einer log. 0, so wird durch das Auslesen das auf der Bitleitung BL liegende (Precharge-)Potential VPC um einen dem Lesesignal entsprechenden Betrag V0 erniedrigt. Diese Phase ist in FIG 2 folgendermaßen dargestellt: Der Wert des Precharge-Potentials VPC ist punktiert eingezeichnet ab dem Zeitpunkt t2. Der um den Betrag V1 erhöhte Potentialwert der Bitleitung BL ist mit einer voll durchgezogenen Linie dargestellt ab dem Zeitpunkt t2. Der um den Betrag V0 erniedrigte Potentialwert der Bitleitung BL ist gestrichelt dargestellt ab dem Zeitpunkt t2.

Zu einem Zeitpunkt t3 wird das eine Taktsignal $\overline{SAN}$ aktiviert. Bis zu diesem Zeitpunkt weist die Referenzbitleitung $\overline{BL}$ auf jeden Fall ihr Precharge-Potential VPC auf. Ist die Bitleitung BL zum Zeitpunkt t3 auf den um den Betrag V1 erhöhten Potential, so nimmt die Referenzbitleitung $\overline{BL}$ jetzt den Wert log. 0 an (mit einer voll durchgezogenen Linie dargestellt), wohingegen die Bitleitung BL unverändert bleibt. Ist die Bitleitung BL zum Zeitpunkt t3 jedoch auf dem um den Betrag V0 erniedrigten Potential, so nimmt die Bitleitung BL den Wert log. 0 an, während die Referenzbitleitung $\overline{BL}$ unverändert ihr Precharge-Potential VPC beibehält (gestrichelt dargestellt). Dies ist eine erste Phase des Bewerte- und Verstärkungsvorganges.

Daran schließt sich zu einem Zeitpunkt t4 eine zweite Phase an: Zum Zeitpunkt t4 wird das andere Taktsignal SAP aktiviert. Liegt zu diesem Zeitpunkt die Bitleitung BL auf dem um den Betrag V1 erhöhten Potential, so nimmt die Bitleitung BL nunmehr den Wert log. 1 an; die Referenzbitleitung $\overline{BL}$ bleibt unverändert auf log. 0. Liegt die Bitleitung BL jedoch bereits auf log. 0, so nimmt die Referenzbitleitung $\overline{BL}$ den Wert log. 1 an.

In einem späteren Zeitpunkt t5 wird die Wortleitung WL wieder deaktiviert. Anschließend (Zeitpunkt t6) werden die Taktsignale $\overline{SAN}$ und SAP deaktiviert und das Ausgleichssignal EQL aktiviert. Die Bitleitung BL und die Referenzbitleitung $\overline{BL}$ nehmen demzufolge wieder das Precharge-Potential VPC an. Der Einfachheit halber werden in FIG 2 (und auch in den nachfolgend noch zu beschreibenden weiteren Impulsdiagrammen) der Wert "log. 1" potentialmäßig gleichgesetzt mit einem ersten Versorgungspotential VDD und der Wert "log. 0" potentialmäßig gleichgesetzt einem zweiten Versorgungspotential VSS des Halbleiterspeichers. Dies ist jedoch nur beispielhaft; andere Potentialwerte sind möglich. Die Taktsignale $\overline{\text{SAN}}$, SAP weisen im inaktiven Zustand das Precharge-Potential VPC auf und im aktiven Zustand die Werte log. 0 bzw. log. 1.

Nach FIG 3 weist der integrierte Halbleiterspeicher erfindungsgemäß je Bitleitung BL und Referenzbitleitung $\overline{\text{BL}}$ eine Koppelkapazität CK auf. Der erste Anschluß jeder Koppelkapazität CK ist mit der Bitleitung BL bzw. mit der Referenzbitleitung $\overline{\text{BL}}$ verbunden. Die zweiten Anschlüsse der Koppelkapazitäten CK sind gemeinsam mit einer Steuerleitung CTRL verbunden. Damit läßt sich im Betrieb (hierbei ist insbesondere ein Testbetrieb des Halbleiterspeichers vorgesehen) ein zusätzliches Potential $\Delta$VPC auf das Bitleitungspaar BL,$\overline{\text{BL}}$ einkoppeln, was je nach Ausgestaltung eines Testsignales Test, mit dem die Steuerleitung CTRL beaufschlagbar ist, zu einer Erhöhung oder einer Erniedrigung der Potentiale auf dem Bitleitungspaar BL,$\overline{\text{BL}}$ um das genannte zusätzliche Potential $\Delta$VPC führt. Wirkungsweise und Sinn dieser Anordnung werden nachstehend anhand von Impulsdiagrammen (FIG 4 bis 7) erläutert:

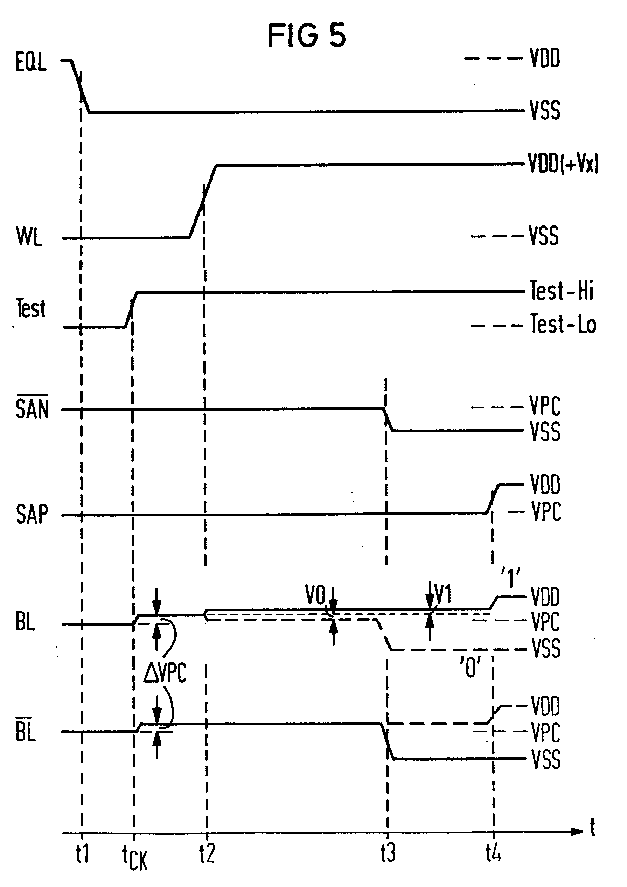

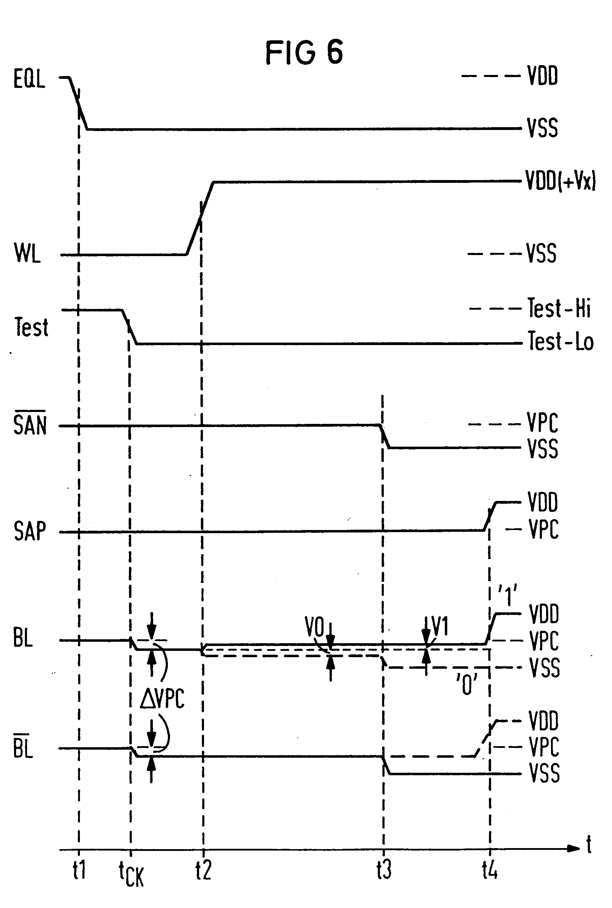

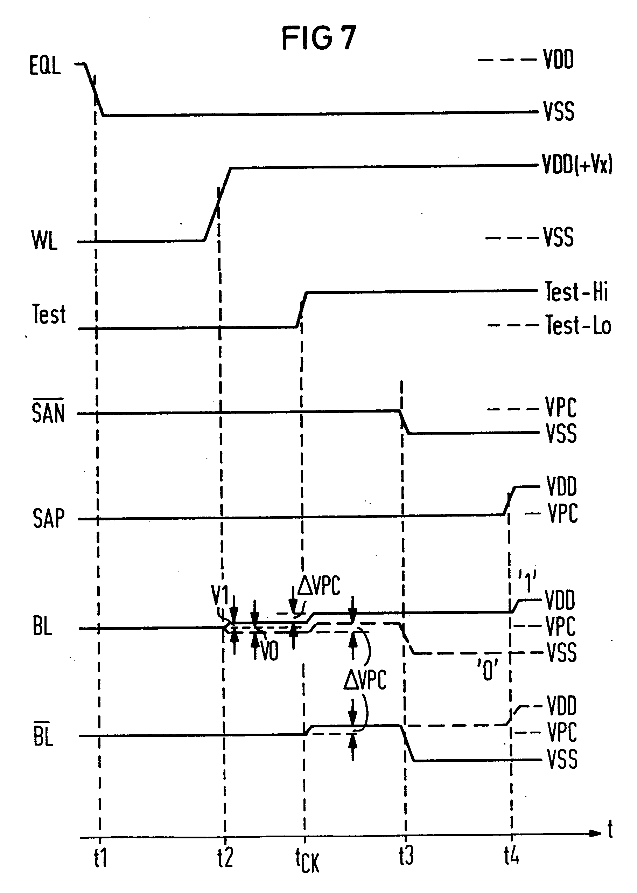

FIG 4 zeigt das Impulsdiagramm nach FIG 2, ergänzt um das Testsignal Test (zwei mögliche Verläufe sind angedeutet) sowie seine Auswirkungen auf das Bitleitungspaar BL,$\overline{\text{BL}}$. Das Testsignal Test bewirkt mittels eines Flankenwechsels zu einem Zeitpunkt $t_{CK}$ das Einkoppeln des zusätzlichen Potentials $\Delta$VPC auf das Bitleitungspaar BL,$\overline{\text{BL}}$. Der Flankenwechsel findet frühestens mit Beenden des Vorladevorganges (Zeitpunkt t1) und spätestens vor Beginn des Bewerte- und Verstärkungsvorganges (Zeitpunkt t3) statt. Zur Verdeutlichung des gesamten Vorganges ist der Zeitraum zwischen den Zeitpunkten kurz vor t1 und kurz nach t4 in den FIG 5 bis 7 vergrößert dargestellt. Die FIG 5 und 7 zeigen einen positiven Flankenwechsel des Testsignals Test; FIG 6 zeigt einen negativen Flankenwechsel. Weiterhin liegt der Zeitpunkt $t_{CK}$ des Flankenwechsels bei den FIG 5 und 6 zwischen den Zeitpunkten t1 und t2; in FIG 7 leigt er zwischen den Zeitpunkten t2 und t3. Zunächst wird FIG 4 in Verbindung mit FIG 5 näher erläutert:

Bis zum Zeitpunkt t1 besteht kein Unterschied zwischen den Impulsdiagrammen nach den FIG 2 und 4, abgesehen vom Testsignal Test. Dieses weist gemäß FIG 4 einen ersten Pegel auf. Nach FIG 5 sei dies ein Low-Pegel Test-Lo (in FIG 4 mit einer voll durchgezogenen Linie dargestellt). Zum Zeitpunkt $t_{CK}$ findet der genannte Flankenwechsel statt: Das Testsignal Test nimmt einen zweiten Pegel an, im Falle von FIG 5 einen High-Pegel Test-Hi.

Dadurch wird über die Koppelkapazitäten CK auf die Bitleitung BL und auf die Referenzbitleitung $\overline{\text{BL}}$ ein zusätzliches Potential $\Delta$VPC eingekoppelt, wodurch Bitleitung BL und Referenzbitleitung $\overline{\text{BL}}$ ein um das zusätzliche Potential $\Delta$VPC erhöhtes Potential annehmen. Beim nachfolgenden Aktivieren der Wortleitung WL wirkt sich der entsprechende Betrag V1 (bzw. V0), der dem Lesesignal entspricht, auf das um das zusätzliche Potential $\Delta$VPC erhöhte Gesamtpotential der Bitleitung BL aus und hebt dieses entsprechend weiter an um den Betrag V1 (bzw. verringert es um den Betrag V0). Auf die Referenzbitleitung $\overline{\text{BL}}$ wirkt sich das Lesesignal nicht aus, analog zur Darstellung nach FIG 2, wodurch die Referenzbitleitung $\overline{\text{BL}}$ ihr um das zusätzliche Potential $\Delta$VPC erhöhte Potential beibehält. Zu den Zeitpunkten t3 und t4 werden dann, wie bereits in FIG 2 erläutert, die Taktsignale $\overline{\text{SAN}}$ und SAP aktiviert, was den Bewerte- und Verstärkungsvorgang mittels der Bewerterschaltung AMP bewirkt. Spätestens zum Zeitpunkt t6 (beispielsweise zum Zeitpunkt t5) nimmt das Testsignal Test wieder seinen ursprünglichen Zustand ein.

Beim Impulsdiagramm nach FIG 5, wie vorstehend beschrieben, weist das Testsignal Test zum Zeitpunkt $t_{CK}$ einen positiven Flankenwechsel auf ("positive going"). Beim Impulsdiagramm nach FIG 6 hingegen weist das Testsignal Test zum Zeitpunkt $t_{CK}$ einen negativen Flankenwechsel auf ("negative going"). Demzufolge wird das Precharge-Potential VPC des Bitleitungspaares BL,$\overline{\text{BL}}$ um den Betrag $\Delta$VPC erniedrigt. Der weitere Verlauf ist analog zum bereits beschriebenen Verlauf nach FIG 5.

Das Impulsdiagramm nach FIG 7 weist zwar wiederum einen positiven Flankenwechsel auf (vgl. FIG 5); der Zeitpunkt $t_{CK}$ des Flankenwechsels liegt jedoch zwischen den Zeitpunkten t2 und t3. Dies hat zwar zur Folge, daß zum Zeitpunkt $t_{CK}$ des Einkoppelns des zusätzlichen Potentials $\Delta$VPC auf das Bitleitungspaar BL,$\overline{\text{BL}}$ die Bitleitung BL bereits ein Potential aufweist, das gegenüber dem Precharge-Potential VPC um das Lesesignal V1 bzw. V0 angehoben bzw. abgesenkt ist. Verglichen mit dem Impulsdiagramm nach FIG 5 hat dies jedoch auf die Bewertung und Verstärkung, d.h. auf die Vorgänge ab dem Zeitpunkt t3, keinerlei unterschiedlichen Einfluß, da zum Zeitpunkt t3 sowohl die Bitleitung BL wie auch die Referenzbitleitung $\overline{\text{BL}}$ bei beiden FIG 5 und 7 (gleiche Lesesignale V1 bzw. V0 und gleiche Precharge-Potentiale VPC vorausgesetzt) jeweils dasselbe Gesamtpotential VPC + V1 (bzw. -V0) + $\Delta$VPC (Bitleitung BL) bzw. VPC + $\Delta$VPC (Referenzbitleitung $\overline{\text{BL}}$) aufweisen.

In Weiterbildung der Erfindung ist es vorteilhaft, daß der High-Pegel Test-Hi des Testsignals Test ein variabel vorwählbarer Wert ist. Ebenso ist es vorteilhaft, daß der Low-Pegel Test-Lo des Testsignals Test ein variabel vorwählbarer Wert ist. Der Vorteil liegt darin, daß mittels des variabel vorwählbaren Wertes des High-Pegels Test-Hi und/oder des Low-Pegels Test-Lo das zusätzliche Potential $\Delta$VPC betragsmäßig variierbar ist.

Weiterhin ist es vorteilhaft, daß die das Einkoppeln bestimmende Flanke des Testsignals Test sowohl eine positive wie auch eine negative Flanke sein kann, da dadurch die Potentiale der Bitleitung BL und der Referenzbitleitung $\overline{BL}$ sowohl vergrößert wie auch verringert werden können.

Weiterhin ist es vorteilhaft, daß die Steuerleitung CTRL beispielsweise im Normalbetrieb elektrisch floatend geschaltet ist, d.h. nicht mit dem Testsignal Test verbunden ist oder daß es im Normalbetrieb mit einem festen Potential verbunden ist. Dies gewährleistet einen vom Testsignal Test unabhängigen Betrieb des Halbleiterspeichers; d.h. es findet dann kein Einkoppeln des zusätzlichen Potentials $\Delta$VPC statt. Das Ankoppeln des Testsignals Test an die Steuerleitung CTRL bzw. dessen Abkoppeln läßt sich beispielsweise durch die bekannte Impulsfolge "$\overline{CAS}$-before-$\overline{RAS}$" als Steuerungsmittel erreichen (s. dazu die bereits angegebene Literatur "IEEE Journal of Solid-State Circuits, VOL. SC-22", speziell Abschnitt III). Der "$\overline{CAS}$-before-$\overline{RAS}$"-Betrei zum Durchführen irgendwelcher Tests in einem integrierten Halbleiterspeicher ist ein dem Fachmann mittlerweile selbst verständliches Hilfsmittel.

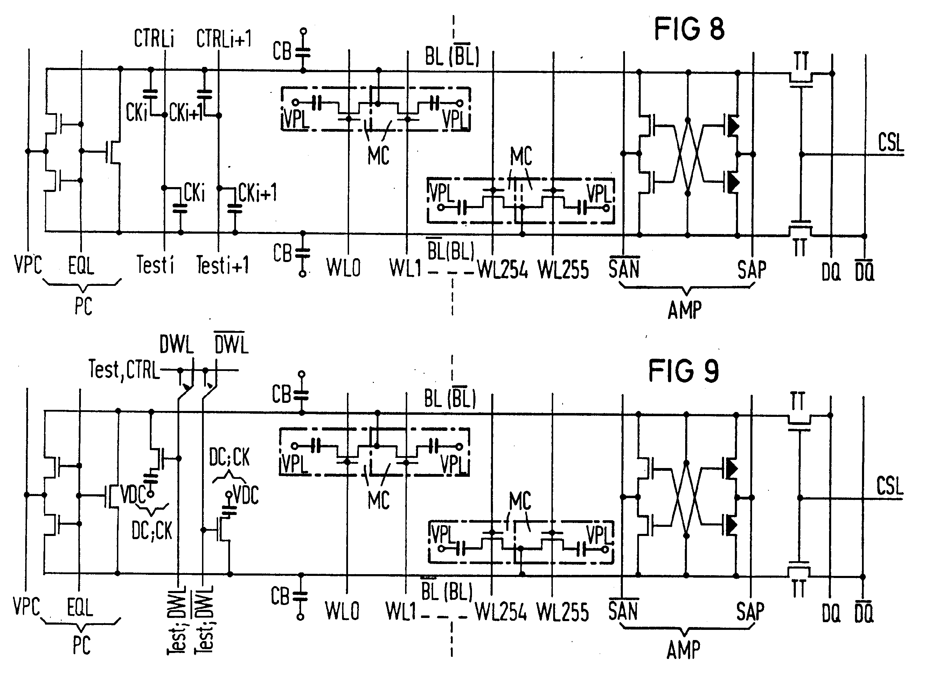

Gemäß der Darstellung nach FIG 8 ist es weiterhin vorteilhaft, anstelle oder zusätzlich zu den Koppelkapazitäten CK samt zugehöriger Steuerleitung CTRL je Bitleitungspaar BL,$\overline{BL}$ mehrere Koppelkapazitäten CKi je Bitleitung BL und Referenzbitleitung $\overline{BL}$ vorzusehen mit Steuerleitungen CTRLi, die unabhängig voneinander mit Testsignalen Testi verbindbar sind im Betrieb. Die Testsignale Testi haben in einer ersten Ausführung fest vorgegebene High- bzw. Low-Pegel Test-Hi,Test-Lo. In Weiterbildung sind jedoch auch variabel vorwählbare Pegel vorsehbar. Die Vorwahl der High- und Low-Pegel das Testsignals Test bzw. der Testsignale Testi erfolgt der Einfachheit halber ebenfalls über den genannten "$\overline{CAS}$-before-$\overline{RAS}$"-Betrieb mit Hilfe einer einfachen Auswahlschaltung, durch Abgriff von einer Widerstandskette o.ä. Vorteilhafterweise sind dabei die Testsignale Testi auch einzeln schaltbar.

Der Einsatz mehrerer Koppelkapazitäten CKi anstelle bzw. zusätzlich zu einer einzigen Koppelkapazität CK je Bitleitung BL und Referenzbitleitung $\overline{BL}$ ermöglicht ebenso wie die variable Wählbarkeit von High- und/oder Low-Pegel Test-Hi,Test-Lo des Testsignals Test bzw. der Testsignale Testi eine Variation des Wertes des zusätzlichen Potentials $\Delta$VPC. Der Wert des zusätzlichen Potentials $\Delta$VPC ist nach folgender Formel bestimmbar:

$$\Delta VPC = (Test\text{-}Hi - Test\text{-}Lo) \cdot \frac{CK}{CK + CB},$$

wobei CB den Wert der Kapazität einer Bitleitung BL bzw. einer Referenzbitleitung $\overline{BL}$ darstellt und die restlichen Operanden den Wert darstellen, den die unter dem gleichen Bezugszeichen beschriebenen Elemente aufweisen.

Betragen beispielsweise das erste Versorgungspotential VDD = 5 V, das zweite Versorgungspotential VSS = 0 V und der Betrag eines typischen Lesesignals = 50 mV, so ist es günstig, in verschiedenen Testzyklen die Werte der zusätzlichen Potentiale $\Delta$VPC von beispielsweise 50 mV bis 500 mV in Stufen von wiederum 50 mV festzulegen.

Wichtige Vorteile der vorliegenden Erfindung sind:
- Analysemöglichkeit von Empfindlichkeit, Geschwindigkeit und Symmetrieverhalten (bezüglich Unterscheidbarkeit von log. 0 gegenüber log. 1 beim Lesesignal) der Bewerter- und Verstärkerschaltungen AMP sowie der Speicherzellen MC durch Variation des Precharge-Potentials VPC mittels des zusätzlichen Potentials $\Delta$VPC;
- Analysemöglichkeit hinsichtlich der Größe und der Veränderung der Lesesignale V1,V0 und möglicher unterschiedlicher Werte der einzelnen Speicherkapazitäten der Speicherzellen MC in Abhängigkeit vom zusätzlichen Potential $\Delta$VPC über nachfolgende Formel:

$$\Delta V1, \Delta V0 = \Delta VPC \cdot \frac{C_{MC}}{C_{MC} + CB},$$

wobei $\Delta$V1 und $\Delta$V0 die auftretende Änderung des Lesesignals in Abhängigkeit von der Änderung des zusätzlichen Potentials $\Delta$VPC bedeuten beim Auslesen von Informationen, die einer log. 1 bzw. einer log. 0 entsprechen, und wobei $C_{MC}$ die Größe der Speicherkapazität der ausgelesenen Speicherzelle MC darstellt.

Diese Analysemöglichkeiten sind beim Stand der Technik entweder überhaupt nicht gegeben oder sie erfordern einen hohen apparativen Aufwand.

Die vorliegende Erfindung wurde anhand eines integrierten Halbleiterspeichers erläutert, der keine sog. Dummy-Zellen aufweist. Sie ist jedoch ebenfalls anwendbar auf integrierte Halbleiter, die diese Dummy-Zellen aufweisen. Als Dummy-Zellen sind prinzipiell zwei verschiedene Möglichkeiten der Realisierung bekannt:

a) Dummy-Zelle DC als 1-Transistor-Speicherzelle ausgelegt, d.h. mit Auswahl-Transistor und Speicherkapazität (meist halb so groß wie die Speicherkapazität einer "normalen" Speicherzelle MC),

b) Dummy-Zelle in Form von "Complementary Capacitor-Coupled Dummy-Cell" (vgl. bereits angegebene Literaturstelle "IEEE Journal of Solid-State Circuits, Vol. SC-20", insbesondere FIG 2 und 3).

FIG 9 zeigt eine Anwendung der vorliegenden Erfindung auf Fall a). Die Dummy-Zellen sind mit DC bezeichnet. Die Kapazitäten der Dummy-Zellen DC liegen, wie üblich, einseitig auf einem festen Potential. Im Testfall wird nicht, wie im Normalfall üblich, der Auswahltransistor einer einzigen Dummy-Zelle DC des Bitleitungspaares BL,$\overline{BL}$ mittels einer als Dummy-Wortleitung DWL (bzw. $\overline{DWL}$) wirkenden Leitung angesteuert (dabei würde der Auswahltransistor voll leitend geschaltet), sondern es werden die Auswahltransistoren aller Dummy-Zellen eines Bitleitungspaares BL,$\overline{BL}$ über das Testsignal Test der vorbeschriebenen Art führende, als gemeinsame Steuerleitung CTRL wirkende Leitungen angesteuert. Damit schalten beide Auswahltransistoren in Abhängigkeit vom Wert des Testsignales Test teilweise durch, wodurch sich ein zusätzliches Potential $\Delta$VPC auf Bitleitung BL und Referenzbitleitung $\overline{BL}$ ausbildet, das wertemäßig vom Testsignal Test bestimmt ist. Mit dieser Ausführungsform läßt sich jedoch lediglich ein Absenken des Potentials des Bitleitungspaares BL, $\overline{BL}$ um das zusätzliche Potential $\Delta$VPC erzielen.

Das zusätzliche Potential $\Delta$VPC ist jedoch auch erzielbar, wenn das Testsignal Test Pegel aufweist, die gleich logischen Pegeln (log. 0, log.1) sind. Dann ist es jedoch günstig, um das zusätzliche Potential $\Delta$VPC variabel einstellen zu können, wenn die Kapazitäten der Dummy-Zellen DC einseitig an einem variablen, einstellbaren Potential VDC liegen.

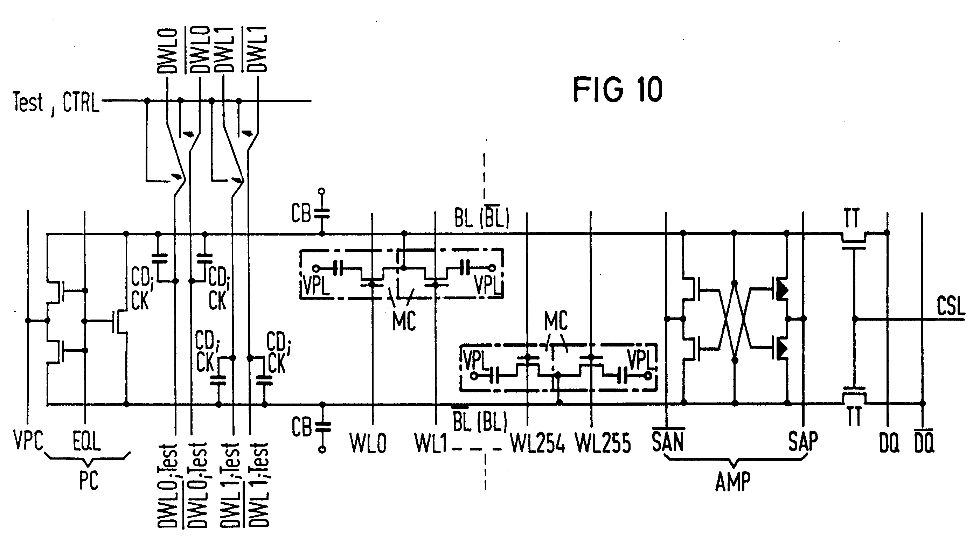

Ähnlich ist die Anwendung der Erfindung bei Fall b) (s. FIG. 10): Jede Koppelkapazität CK gemäß FIG 3 entspricht in FIG 10 jeweils zwei (im Testfall parallelgeschalteten) Kompensationszellen CD.

Die Parallelschaltung wird erreicht, indem im Testfall anstelle einer Ansteuerung mittels der Dummy-Wortleitungen DWL0,$\overline{DWL0}$ (für die Bitleitung BL) und mittels der Dummy-Wortleitungen DWL1,$\overline{DWL1}$ (für die Referenzbitleitung $\overline{BL}$) eine gemeinsame Ansteuerung mittels des Testsignals Test erfolgt.

Vorteilhaft in den Fällen a) und b) ist es, daß die vorhandenen Dummy-Zellen DC durch Beschalten mit dem Testsignal Test im Testfall die Funktion der Koppelkapazitäten CK übernehmen können unter Aufgabe ihrer Funktion als Dummy-Zellen. Im Testfall weist der integrierte Halbleiterspeicher demzufolge keine Dummy-Zellen DC auf, sondern Koppelkapazitäten CK im Sinne der vorliegenden Erfindung. Diese Doppelfunktion ermöglicht einen minimalen Flächenbedarf für die vorliegende Erfindung.

## Patentansprüche

1. Integrierter Halbleiterspeicher vom Typ DRAM mit Wortleitungen (WL), mit Bitleitungspaaren (BL, $\overline{BL}$), mit matrixfärmig angeordneten Speicherzellen (MC) und mit einer Bewerterschaltung (AMPL) je Bitleitungspaar (BL, $\overline{BL}$), bei dem jedes Bitleitungspaar (BL, $\overline{BL}$) im Betrieb in eine Bitleitung (BL) und in eine Referenzbitleitung ($\overline{BL}$) eingeteilt ist, bei dem jede Bitleitung (BL) und jede Referenzbitleitung ($\overline{BL}$) wenigstens eine Koppelkapazität (CK; CKi) aufweisen, deren erste Anschlüsse mit dem Bitleitungspaar (BL, $\overline{BL}$) verbunden sind und deren zweite Anschlüsse gemeinsam mit einer Steuerleitung (CTRL, CTRLi) verbunden sind, **dadurch gekennzeichnet,** daß die Steuerleitung (CTRL, CTRLi) so beschaltet ist, daß sie in einem Testbetrieb mit einem Testsignal (Test) beaufschlagbar ist.

2. Integrierter Halbleiterspeicher nach Anspruch 1, **dadurch gekennzeichnet,** daß die Steuerleitung (CTRL) so beschaltet ist, daß sie in einem Normalbetrieb ein festes Potential aufweist.

3. Integrierter Halbleiterspeicher nach Anspruch 1, **dadurch gekennzeichnet,** daß die Steuerleitung (CTRL) so beschaltet ist, daß sie in einem Normalbetrieb einen elektrisch floatenden Zustand aufweist.

4. Integrierter Halbleiterspeicher nach einem der vorhergehenden Ansprüche, **dadurch gekennzeichnet,** daß der High-Pegel (Test-Hi) des Testsignals (Test) vorwählbar ist.

5. Integrierter Halbleiterspeicher nach einem der vorhergehenden Ansprüche, **dadurch gekennzeichnet,** daß der Low-Pegel (Test-Lo) des Testsignals (Test) vorwählbar ist.

6. Integrierter Halbleiterspeicher nach einem der Ansprüche 4 bis 5, **dadurch gekennzeichnet,** daß bei Vorhandensein von mehr als einer Steuerleitung (CTRLi) diese Steuerleitungen so geschaltet sind, daß wenigstens eine der Steuerleitungen im Testbetrieb ein festes Potential aufweist.

7. Integrierter Halbleiterspeicher nach einem der Ansprüche 4 bis 6, **dadurch gekennzeichnet,** daß bei Vorhandensein von mehr als einer Steuerleitung (CTRLi) diese Steuerleitungen so geschaltet sind, daß wenigstens eine der Steuerleitungen im Testbetrieb einen elektrisch floatenden Zustand aufweist.

**8.** Integrierter Halbleiterspeicher nach einem der vorhergehenden Ansprüche, **dadurch gekennzeichnet,** daß in dem Fall, in dem jede Bitleitung (BL) und jede Referenzbitleitung ($\overline{BL}$) mehr als eine Koppelkapazität (CKi) mit Steuerleitungen (CTRLi) aufweisen, im Betrieb die zugeordneten Testsignale (Testi) unabhängig voneinander aktivierbar sind.

**9.** Integrierter Halbleiterspeicher nach einem der vorhergehenden Ansprüche und mit Dummy-Zeilen (DC; CD), **dadurch gekennzeichnet,** daß im Testbetrieb die Dummy-Zeilen (DC; CD) als Koppelkapazitäten (CK) verwendet werden und daß anstelle einer Ansteuerung mit Dummy-Wortleitungen (DWL, $\overline{DWL}$; DWLO, $\overline{DWLO}$; DWL1, $\overline{DWL1}$) eine Ansteuerung mit wenigstens einem Testsignal (Test; Testi) erfolgt, so daß die Funktion als Dummy-Zelle verloren geht.

**10.** Verfahren zum Testen eines integrierten Halbleiterspeichers vom Typ DRAM, bei dem in Speicherzellen (MC) gespeicherte Daten aus den Speicherzellen (MC) ausgelesen werden und bei dem Bitleitungspaare (BL, $\overline{BL}$) vor dem Auslesen auf einen Precharge-Pegel (VPC) vorgeladen werden (t1), **dadurch gekennzeichnet**, daß nach dem Vorladen (t1) auf jedes Bitleitungspaar (BL, $\overline{BL}$) ein zusätzliches Potential ($\Delta$VPC) mittels wenigstens eines Testsignals (Test; Testi) eingekoppelt ($t_{CK}$) wird.

**11.** Verfahren nach Anspruch 10, **dadurch gekennzeichnet,** daß das zusätzliche Potential ($\Delta$VPC) über Koppelkapazitäten (CK) eingekoppelt ($t_{CK}$) wird.

**12.** Verfahren nach Anspruch 10 oder 11, **dadurch gekennzeichnet**, daß das Einkoppeln ($t_{CK}$) mittels einer Flanke des Testsignals (Test; Testi) erfolgt.

**13.** Verfahren nach Anspruch 12, **dadurch gekennzeichnet,** daß als Flanke eine positive Flanke des Testsignals (Test; Testi) benutzt wird.

**14.** Verfahren nach Anspruch 12, **dadurch gekennzeichnet,** daß als Flanke eine negative Flanke des Testsignals (Test; Testi) benutzt wird.

## Claims

**1.** Integrated semiconductor memory of the DRAM-type, having word lines (WL), having bit line pairs (BL, $\overline{BL}$), having memory cells (MC) arranged in the form of a matrix, and having an evaluator circuit (AMPL) for each bit line pair (BL, $\overline{BL}$), in which each bit line pair (BL, $\overline{BL}$) is divided during operation into one bit line (BL) and into one reference bit line ($\overline{BL}$), in which each bit line (BL) and each reference bit line ($\overline{BL}$) have at least one coupling capacitor (CK, CKi), the first terminals of which are connected to the bit line pair (BL, $\overline{BL}$) and the second terminals of which are connected jointly to a control line (CTRL, CTRLi), characterized in that the control line (CTRL, CTRLi) is connected in such a way that it can receive a test signal (Test) during a test mode.

**2.** Integrated semiconductor memory according to Claim 1, characterized in that the control line (CTRL) is connected in such a way that it has a fixed potential in a normal mode.

**3.** Integrated semiconductor memory according to Claim 1, characterized in that the control line (CTRL) is connected in such a way that it has an electrically floating state in a normal mode.

**4.** Integrated semiconductor memory according to one of the preceding claims, characterized in that the high level (Test-Hi) of the test signal (Test) can be preselected.

**5.** Integrated semiconductor memory according to one of the preceding claims, characterized in that the low level (Test-Lo) of the test signal (Test) can be preselected.

**6.** Integrated semiconductor memory according to one of Claims 4 to 5, characterized in that if more than one control line (CTRLi) is present, said control lines are connected in such a way that at least one of the control lines has a fixed potential in the test mode.

**7.** Integrated semiconductor memory according to one of Claims 4 to 6, characterized in that if more than one control line (CTRLi) is present, said control lines are connected in such a way that at least one of the control lines has an electrically floating state in the test mode.

**8.** Integrated semiconductor memory according to one of the preceding claims, characterized in that in the case where each bit line (BL) and each reference bit line ($\overline{BL}$) have more than one coupling capacitor (CKi) with control lines (CTRLi), the assigned test signals (Testi) can be activated independently of one another during operation.

**9.** Integrated semiconductor memory according to one of the preceding claims and having dummy cells (DC; CD), characterized in that in the test mode the dummy rows (DC; CD) are used as coupling capacitors (CK), and in that activation is carried out with at least one test signal (Test; Testi) instead of activation with dummy word lines (DWL, $\overline{DWL}$; DWL0, $\overline{DWL0}$; DWL1, $\overline{DWL1}$;), so that the function as dummy cell is lost.

**10.** Method for testing an integrated semiconductor memory of the DRAM-type, in which data stored in memory cells (MC) are read out of the memory cells (MC), and in which bit line pairs (BL, $\overline{BL}$) are precharged (t1) to a precharge level (VPC) before reading out, characterized in that after the precharging (t1), an additional potential ($\Delta$VPC) is coupled into ($t_{CK}$) each bit line pair (BL, $\overline{BL}$) by means of at least one test signal (Test, Testi).

**11.** Method according to Claim 10, characterized in that the additional potential ($\Delta$VPC) is coupled in ($t_{CK}$) via coupling capacitors (CK).

**12.** Method according to Claim 10 or 11, characterized in that the coupling in ($t_{CK}$) is performed by means of an edge of the test signal (Test, Testi).

**13.** Method according to Claim 12, characterized in that a positive edge of the test signal (Test, Testi) is used as the edge.

**14.** Method according to Claim 12, characterized in that a negative edge of the test signal (Test, Testi) is used as the edge.

## Revendications

**1.** Mémoire intégrée à semiconducteurs du type DRAM comportant des lignes de transmission de mots (W), des couples de lignes de transmission de bits (BL,$\overline{BL}$), des cellules de mémoire (MC) disposées sous forme matricielle et un circuit d'évaluation (AMPL) prévu pour chaque couple de lignes de transmission de bits (BL,$\overline{BL}$), et dans laquelle le couple de lignes de transmision (BL,$\overline{BL}$) est subdivisé, en fonctionnement, en une ligne de transmission de bits (BL) et une ligne de transmission de bits de référence ($\overline{BL}$), chaque ligne de transmission de bits (BL) et chaque ligne de transmission de bits de référence ($\overline{BL}$) possèdent au moins une capacité de couplage (CK; CKi), dont les premières bornes sont reliées au couple de ligne de transmission de bits (BL, $\overline{BL}$) et dont les secondes bornes sont reliées en commun à une ligne de commande (CTRL, CTRLi), caractérisée par le fait que la ligne de commande (CTRL, CTRLi) est câblée de telle sorte qu'elle peut être chargée par un signal de test (Test) lors d'un fonctionnement de test.

**2.** Mémoire intégrée à semiconducteurs suivant la revendication 1, caractérisée par le fait que la ligne de commande (CTRL) est câblée de telle sorte qu'elle possède un potentiel fixe pendant le fonctionnement normal.

**3.** Mémoire intégrée à semiconducteurs suivant la revendication 1, caractérisée par le fait que la ligne de commande (CTRL) est câblée de telle sorte qu'elle possède un état électrique flottant pendant le fonctionnement normal.

**4.** Mémoire intégrée à semiconducteurs suivant l'une des revendications précédentes, caractérisée par le fait que le niveau haut (Test-Hi) du signal de test (Test) peut être présélectionné.

**5.** Mémoire intégrée à semiconducteurs suivant l'une des revendications précédentes, caractérisée par le fait que le niveau bas (Test-Lo) du signal de test (Test) peut être présélectionné.

**6.** Mémoire intégrée à semiconducteurs suivant l'une des revendications 4 à 5, caractérisée par le fait que dans le cas de la présence de plus d'une ligne de commande (CTRLi), ces lignes de commande sont raccordées de telle sorte qu'au moins l'une des lignes de commande possède un potentiel fixe pendant le fonctionnement de test.

7. Mémoire intégrée à semiconducteurs suivant l'une des revendications 4 à 6, caractérisée par le fait que dans le cas de la présence de plus d'une ligne de commande (CTRLi), ces lignes de commande sont raccordées de telle sorte qu'au moins l'une des lignes de commande possède un état électrique flottant lors de l'opération de test.

8. Mémoire intégrée à semiconducteurs suivant l'une des revendications précédentes, caractérisée par le fait que dans le cas où chaque ligne de transmission de bits (BL) et chaque ligne de transmission de bits de référence ($\overline{BL}$) possède plus d'une capacité de couplage (CKi) avec des lignes de commande (CTRLi), les signaux de test associés (Testi) peuvent, en fonctionnement, être activés indépendamment les uns des autres.

9. Mémoire intégrée à semiconducteurs suivant l'une des revendications précédentes et comportant des lignes fictives (DC; CD), caractérisée par le fait que lors de l'opération de test, les lignes fictives (DC; CD) sont utilisées comme capacités de couplage (CK) et qu'à la place d'une commande avec des lignes fictives de transmission de mots (DWL, $\overline{DWL}$; DWL0, $\overline{DWLO}$, DWL1, $\overline{DWL1}$), une commande est réalisée avec au moins un signal de test (Test; Testi) de sorte que la fonction en tant que cellule fictive est perdue.

10. Procédé pour tester une mémoire intégrée à semiconducteurs du type DRAM, dans laquelle des données mémorisées dans les cellules (MC) de la mémoire sont lues à partir des cellules de mémoire (MC) et selon lequel des couples de lignes de transmission de bits (BL,$\overline{BL}$) sont préalablement chargés (t) à un niveau de précharge (VPC) avant la lecture, caractérisé par le fait qu'après la précharge (t1), un potentiel supplémentaire ($\Delta VPC$) est injecté ($t_{CK}$) dans chaque couple de lignes de transmission de bits (BL, $\overline{BL}$), à l'aide d'au moins un signal de test (Test; Testi).

11. Procédé suivant la revendication 10, caractérisé par le fait que le potentiel supplémentaire ($\Delta VPC$) est injecté ($t_{CK}$) par l'intermédiaire de capacités de couplage (CK).

12. Procédé suivant la revendication 10 ou 11, caractérisé par le fait que l'injection ($t_{CK}$) est réalisée à l'aide d'au moins un flanc du signal de test (Test; Testi)

13. Procédé suivant la revendication 12, caractérisé par le fait qu'on utilise, comme flanc, un flanc positif du signal de test (Test; Testi).

14. Procédé suivant la revendication 12, caractérisé par le fait qu'on utilise comme flanc un flanc négatif du signal de test (Test; Testi).

FIG 1

FIG 3

FIG 2

FIG 4

# FIG 5

# FIG 6

EP 0 387 379 B1

# FIG 7

14

FIG 8

FIG 9

EP 0 387 379 B1

FIG 10